(19) Europäisches Patentamt
European Patent Office
Office européen des brevets

(11) EP 4 542 242 A1

(12) EUROPEAN PATENT APPLICATION

(43) Date of publication:
23.04.2025 Bulletin 2025/17

(21) Application number: 24187805.7

(22) Date of filing: 10.07.2024

(51) International Patent Classification (IPC):
G01R 31/364 (2019.01)    G01R 31/367 (2019.01)
G01R 31/396 (2019.01)

(52) Cooperative Patent Classification (CPC):
G01R 31/364; G01R 31/367; G01R 31/396

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 17.10.2023 KR 20230138548

(71) Applicant: SAMSUNG SDI CO., LTD.
Giheung-gu
Yongin-si, Gyeonggi-do
17084 (KR)

(72) Inventors:
• LEE, Kun Hee
  16678 Suwon-si (KR)
• LEE, Dae Sung
  16678 Suwon-si (KR)

(74) Representative: Marks & Clerk LLP
15 Fetter Lane
London EC4A 1BW (GB)

(54) APPARATUS AND METHOD FOR PREDICTING DAMAGE TO BATTERY CELL

(57) The present disclosure relates to an apparatus and method for predicting damage to a battery cell. The technical object to be solved by the present disclosure is to provide a method of managing a battery cell by accurately predicting a degree of damage to the battery cell based on a degree and time of a voltage or a temperature exceeding a safety range. To this end, an apparatus for predicting damage to a battery cell according to the present disclosure includes a battery module including a plurality of battery cells, a voltage sensor configured to measure a voltage of the battery cell, a temperature sensor configured to measure a temperature of the battery cell, a contactor configured to connect or disconnect the battery module, and a processor configured to, when at least one of the voltage and the temperature is included in a cell damage range for the battery cell, control the contactor to disconnect the battery module and calculate a weighting for a degree of damage to the battery cell according to at least one of the voltage and the temperature.

FIG. 7

EP 4 542 242 A1

**Description**

**BACKGROUND**

**1. Field**

Aspects of embodiments of the present disclosure relate to an apparatus and method for predicting damage to battery cells.

**2. Description of the Related Art**

Unlike primary batteries that cannot be recharged, secondary batteries are batteries that may be charged and discharged. Low-capacity secondary batteries are used in portable small-sized electronic devices such as a smartphone, a feature phone, a laptop computer, a digital camera, a camcorder, and the like, and high-capacity secondary batteries are widely used as a power supply for driving a motor of a hybrid vehicle, an electric vehicle, or the like, a power storage battery, and the like. Such a secondary battery includes an electrode assembly including a positive electrode and a negative electrode, a case for accommodating the same, and an electrode terminal connected to the electrode assembly.

Secondary batteries are charged by a charging current applied from the outside and output a discharge current to supply the discharge current to a load.

Such secondary batteries may be damaged when a cell voltage or temperature exceeds a safety range.

However, there is no way to prevent cell damage even when a voltage or temperature exceeds a safety range.

Cell damage caused by a voltage or temperature exceeding a safety range occurs variably according to a degree of exposure, and in particular, a degree of cell damage may variably occur according to an exposure time.

However, even when cell damage occurs when a voltage or temperature exceeds a safety range, there is a problem that an exact degree of damage cannot be confirmed because a history of the voltage or temperature exceeding the safety range cannot be checked.

Therefore, there is a need for a method of predicting a degree of damage by checking a history of a voltage, a temperature, or the like exceeding a safety range.

The above information disclosed in this section of BACKGROUND is only for enhancement of understanding of the background of the present disclosure and therefore it may contain information that does not form the related art.

**SUMMARY**

The present disclosure is directed to providing an apparatus and method for predicting damage to a battery cell in which a battery cell is managed by accurately predicting damage to the battery cell that occurs when a voltage or temperature of the battery cell deviates from a safety range.

However, the technical object to be solved by the present disclosure is not limited to the above, and other objects not described herein will be clearly understood by those skilled in the art from the following disclosure.

According to an aspect of the present disclosure, there is provided an apparatus for predicting damage to a battery cell, the apparatus including a battery module including a plurality of battery cells, a voltage sensor configured to measure a voltage of a battery cell of the plurality of battery cells, a temperature sensor configured to measure a temperature of the battery cell, a contactor configured to connect or disconnect the battery module, and a processor configured to, in response to at least one of the voltage and the temperature being included in a cell damage range for the battery cell, control the contactor to disconnect the battery module and calculate a weighting for a degree of damage to the battery cell according to at least one of the voltage and the temperature.

At least some of the above and other features of the invention are set out in the claims.

**BRIEF DESCRIPTION OF DRAWINGS**

The following drawings attached to this specification illustrate embodiments of the present disclosure, and further describe aspects and features of the present disclosure together with the detailed description of the present disclosure. Thus, the present disclosure should not be construed as being limited to the drawings:

FIG 1 illustrates an example of a battery module according to one embodiment of the present disclosure.

FIG 2 is a block diagram of an apparatus for predicting damage to a battery cell according to one embodiment of the present disclosure.

FIG 3 shows a weighting setting section according to a temperature in the apparatus for predicting damage to a battery cell according to one embodiment of the present disclosure.

FIG 4 shows a weighting setting section according to a voltage in the apparatus for predicting damage to a battery cell according to one embodiment of the present disclosure.

FIG 5 shows a cell damage section according to a level of an output factor in the apparatus for predicting damage to a battery cell according to one embodiment of the present disclosure.

FIG 6 shows a weighting table according to a level of an output factor in the apparatus for predicting damage to a battery cell according to one embodiment of the present disclosure.

FIG 7 illustrates a method of predicting damage to a battery cell in the apparatus for predicting damage to a battery cell according to one embodiment of the present disclosure.

**DETAILED DESCRIPTION**

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

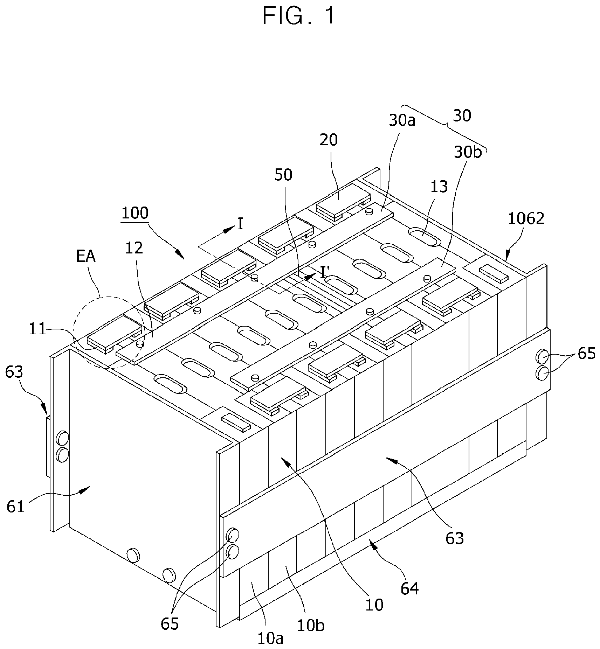

FIG 1 illustrates an example of a battery module according to one embodiment of the present disclosure.

Referring to FIG 1, a battery module 100 according to the present disclosure includes terminal portions 11 and 12, a plurality of battery cells 10 arranged in one direction, a connection tab 20 for connecting the battery cell 10a to an adjacent battery cell 10b, and a protection circuit module 30 of which one end is connected to the connection tab 20. The protection circuit module 30 may be a battery management system (BMS). The connection tab 20 includes a body portion 22 in contact with the terminal portions 11 and 12 of adjacent battery cells 10a and 10b, and an extension portion that extends from the body portion 22 and is connected to the protection circuit module 30. The connection tab 20 may be a busbar.

First, the battery cell 10 may include a battery case, an electrode assembly, and an electrolyte stored in the battery case. The electrode assembly and the electrolyte electrochemically react with each other to generate energy. The terminal portions 11 and 12 are electrically connected to the connection tab 20 and a vent 13 that is a discharge passage for gas generated internally may be provided at one side of the battery cell 10. The terminal portions 11 and 12 of the battery cell 10 may be a positive electrode terminal portion 11 and a negative electrode terminal 12 having different polarities. The terminal portions 11 and 12 of adjacent battery cells 10a and 10b may be electrically connected in series or parallel by the connection tab 20 to be described below. Meanwhile, although an example of serial connection has been described above, the present disclosure is not limited to such a structure, and of course, various connection structures may be adopted as needed. In addition, the number and arrangement of the battery cells 10 are not limited to the structure shown in FIG 1 and may be changed as needed.

The plurality of battery cells 10 may be arranged in one direction such that wide surfaces of the battery cells 10 face each other, and the plurality of arranged battery cells 10 may be fixed by housings 61, 62, 63, and 64. The housings 61, 62, 63, and 64 may include a pair of end plates 61 and 62 facing the wide surfaces of the battery cells 10, and side plates 63 and a bottom plate 64 which connect the pair of end plates 61 and 62. The side plate 63 may support a side surface of the battery cell 10, and the bottom plate 64 may support a bottom surface of the battery cell 10. In addition, the pair of end plates 61 and 62, the side plate 63, and the bottom plate 64 may be connected by fastening members such as bolts 65 or the like.

The protection circuit module 30 may be mounted with electronic components and protection circuits and may be electrically connected to the connection tab 20 to be described below. The protection circuit module 30 may include a first protection circuit module 30a and a second protection circuit module 30b which extend at different positions in a direction in which the plurality of battery cells 10 are arranged. In this case, the first protection circuit module 30a and the second protection circuit module 30b may be spaced a certain interval apart from each other, may be positioned parallel to each other, and may each be electrically connected to the connection tab 20 adjacent thereto. For example, the first protection circuit module 30a may be formed to extend at one upper side of the plurality of battery cells 10 in the direction in which the plurality of battery cells 10 are arranged, and the second protection circuit module 30b may be formed to extend at the other upper side of the plurality of battery cells 10 in the direction in which the plurality of battery cells 10 are arranged. The second protection circuit module 30b may be positioned to be spaced a certain interval apart from the first protection circuit module 30a with the vent 13 interposed therebetween and may be disposed parallel to the first protection circuit module 30a.

In this way, two protection circuit modules are arranged parallel to each other and spaced apart from each other in the direction in which the plurality of battery cells are arranged, thereby minimizing an area of a printed circuit board (PCB) constituting the protection circuit module. The protection circuit module is provided as two separate protection circuit modules, thereby minimizing an unnecessary PCM area. The first protection circuit module 30a and the second protection circuit module 30b may be connected to each other by a conductive connection member 50. In this case, one side of the connection member 50 may be connected to the first protection circuit module 30a, and the other side thereof may be connected to the second protection circuit module 30b so that an electrical connection may be made between the two protection circuit modules. The connection may be performed through any one method of soldering, resistance welding, laser welding, and projection welding methods.

The connection member may be, for example, an electric wire. In addition, the connection member 50 may be made of an elastic or flexible material. Through the connection member 50, it is possible to check and manage whether the voltage, temperature, and current of the plurality of battery cells 10 are normal. That is, information about a voltage, a current, a temperature, or the like received by the first protective circuit module from the connection tabs adjacent thereto and information about a voltage, a current, a temperature, or the like received by the second protective circuit module from the connection tabs adjacent thereto may be integrally managed through the connection member by the protection circuit module.

In addition, when the battery cell 10 swells, an impact is absorbed due to the elasticity or flexibility of the connection member 50, thereby preventing damage to the first and second protection circuit modules 30a and 30b.

In addition, the shape and structure of the connection member 50 are not limited to the shape shown in FIG 1.

In this way, the protection circuit module 30 is provided as the first and second protection circuit modules 30a and 30b, the area of the PCB constituting the protection circuit module can be minimized, thereby securing a space inside the battery module. Thus, a fastening operation of connecting the connection tab 20 and the protection circuit module 30 may be facilitated, and also a repair may be facilitated when an abnormality is detected in the battery module, thereby improving operation efficiency.

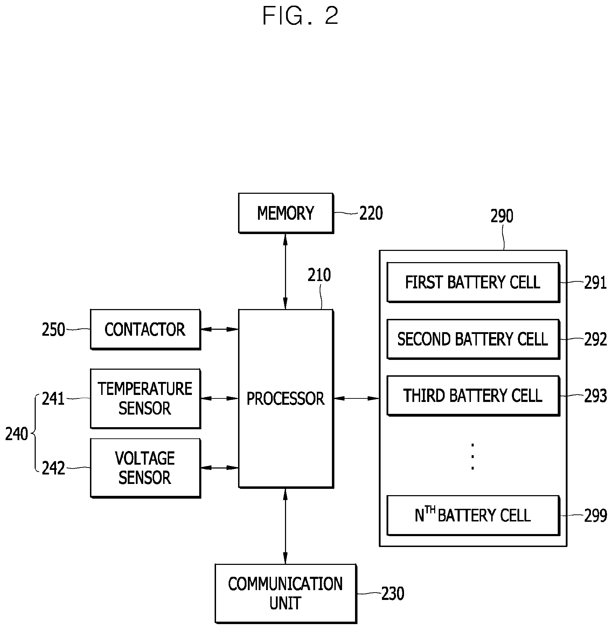

FIG 2 is a block diagram of an apparatus for predicting damage to a battery cell according to one embodiment of the present disclosure.

Referring to FIG 2, an apparatus 200 for predicting damage to a battery cell (hereinafter referred to as a prediction apparatus) according to one embodiment of the present disclosure may include a memory 220, a communication unit 230, a sensor 240, a contactor 250, a battery module 290, and a processor 210.

The memory 220 may store temperature data and voltage data input from the sensor 240, setting data for processing temperature data or voltage data, data about the battery module 290, reference data for determining a state of the battery module 290, state of charge (SOC) data of the battery module 290 or battery cells 291 to 299, and data generated during an arithmetic processing process of the processor 210.

In addition, the memory 220 may store level data, weighting data, accumulated weighting data, specific range data, and cell damage range data for determining damage to the battery cells 291 to 299 based on temperature data and voltage data.

The memory 220 may store data related to at least one of a data processing algorithm, a data level determination algorithm, a weighting setting algorithm, a damage prediction algorithm, a contactor control algorithm, and a battery diagnosis algorithm.

The memory 220 may include a storage element such as a random access memory (RAM), a non-volatile memory such as a read-only memory (ROM), or an electrically erased programmable ROM (EEPROM), or a flash memory.

The communication unit 230 transmits or receives data between the processor 210, the memory 220, the battery module 290, the sensor 240, and the contactor 250. In addition, the communication unit 230 may transmit or receive data between the processor 210 and a main processor (not shown) of a device or an apparatus equipped with the prediction apparatus 200.

For example, the communication unit 230 may include a controller area network (CAN) communication driver or a local interconnect network (LIN) communication driver to transmit or receive data. The communication unit 230 may transmit or receive data through serial communication or parallel communication.

The sensor 240 may include a temperature sensor 241 and a voltage sensor 242. In addition, the sensor 240 may further include a current sensor.

The temperature sensor 241 measures a temperature of the battery module 290. A plurality of temperature sensors 241 may be provided to measure a temperature of each of the battery cells 291 to 299.

The voltage sensor 242 measures a voltage of the battery module 290. A plurality of voltage sensors 242 may be provided to measure a voltage of each of the battery cells 291 to 299.

The voltage sensor 242 may be connected to at least one of an input terminal and an output terminal of each of the battery cells 291 to 299 to measure a voltage.

When a problem occurs in a device or apparatus connected to the battery module 290 or the prediction apparatus 200, the contactor 250 may block the output of the battery module 290 or may block power supplied to the battery module 290 from the outside. The contactor 250 may be turned on or off according to a control command from the processor 210.

The contactor 250 may be a relay, and a mechanical contactor that is turned on or off by a magnetic force of a coil may be used. In addition, as the contactor 250, a semiconductor switch such as a metal oxide semiconductor field effect transistor (MOSFET) may be used.

The battery module 290 may include first to $n^{th}$ battery cells 291 to 299. The plurality of battery cells 291 to 299 may be connected to each other in series or parallel.

The processor 210 may monitor a state of the plurality of battery cells 291 to 299 and determine an SOC to calculate a lifespan (state of health (SOH)). The processor 210 may detect a fault of the battery module 290 and the plurality of battery cells 291 to 299. The processor 210 may control charging and discharging of the plurality of battery cells 291 to 299, may control a temperature of the battery cells 291 to 299, and may perform balancing control.

In addition, the processor 210 may perform at least one function of over-discharge, over-charge, and over-current prevention functions, a short-circuit protection function, and a fire extinguishing function based on a state monitoring result.

As the processor 210, any one of a battery management system (BMS), a battery pack control module (BPCM), a central processing unit (CPU), an electronic control unit (ECU), and a micro controller unit (MCU) may be used.

Based on data input from the temperature sensor 241 and the voltage sensor 242, the processor 210 determines a state of the battery cells 291 to 299 and calculates a degree of damage to the battery cells 291 to 299.

When data of the temperature sensor 241 and the voltage sensor 242 deviates from a preset safety range, that is, is included in a cell damage range, the processor 210 determines that the battery cells 291 to 299 or the battery module 290 is abnormal and controls the contactor 250 to be opened.

When at least one of a temperature and a voltage deviates from a safety range, the processor 210 may determine that the battery cells 291 to 299 are abnormal and may generate an error code or a diagnostic code. The processor 210 may control the contactor 250 and may transmit the error code or diagnostic code to the main processor through the communication unit 230.

In addition, the processor 210 may store data from the temperature sensor 241 and the voltage sensor 242 in the memory 220, may check whether the data deviates from a preset safety range, and may manage a history of the data.

When the data from the temperature sensor 241 and the voltage sensor 242 deviates from the safety range, the processor 210 may calculate a degree of damage to the battery cells 291 to 299 due to a temperature or voltage.

The processor 210 may divide a cell damage range into a plurality of levels, may determine levels for temperature and voltage, and may set a weighting variably. The processor 210 may set a weighting for each of a case in which data from the temperature sensor 241 and the voltage sensor 242 is less than a safety range and a case in which the data exceeds the safety range. The processor 210 may set a weighting based on weighting data stored in the memory 220.

The processor 210 may set a weighting variably according to levels to calculate a degree of damage to the battery cells 291 to 299. In addition, the processor 210 may calculate a degree of damage to the battery cells 291 to 299 based on the number and time at which the data from the temperature sensor 241 and the voltage sensor 242 deviates from the safety range.

The processor 210 may accumulate and store a weighting, which is data about damage to the battery cells 291 to 299, in the memory 220, and may finally determine a degree of damage to the battery cells 10 based on the accumulated weighting. When the accumulated weighting is greater than a set value, the processor 210 may control the contactor 250 to be permanently blocked.

In addition, the processor 210 may determine whether to replace the battery cell 10 according to the accumulated weighting. When a degree of accumulated damage exceeds a set value, the processor 210 may set the corresponding battery cells 291 to 299 as replacement targets.

When it is determined that the battery cells 291 to 299 need to be replaced, the processor 210 may generate a request for replacing the battery cells 291 to 299 and transmit the request to the main processor through the communication unit 230 or output the request through an output component (not shown) in at least one form of a warning sound, a warning light, and a warning message.

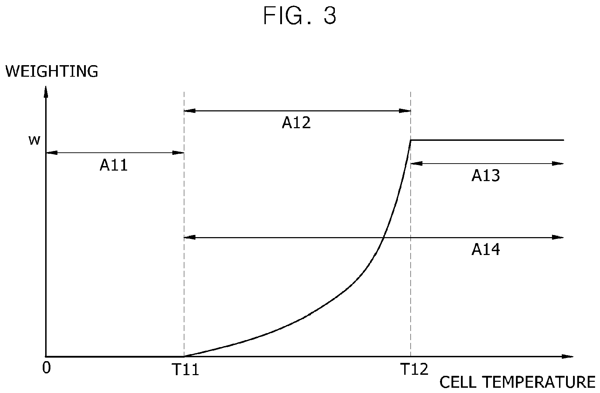

FIG 3 shows a weighting setting section according to a temperature in the apparatus for predicting damage to a battery cell according to one embodiment of the present disclosure.

Referring to FIG 3, when at least one of temperature data and voltage data deviates from a safety range, that is, is included in a cell damage range, the processor 210 may predict damage to the battery cells 291 to 299 according to at least one of a magnitude of a voltage or temperature, a time, and a number.

The processor 210 may set a weighting variably by dividing a degree, by which data about a temperature and voltage deviates from a safety range, into levels.

The processor 210 may set a level of a temperature based on a temperature of 0°, a first reference temperature T11, and a second reference temperature T12.

For example, the processor 210 may set a first section A11, in which a temperature is in a range of 0° to less than the first reference temperature T11, to a first level, may set a second section A12, in which a temperature is in a range of the first reference temperature T11 or more to less than the second reference temperatureT12, to a second level, and may set a third section A13, in which a temperature is the second reference temperature T12 or more, to a third level. In some cases, the processor 210 may subdivide each section to add levels.

The processor 210 may set the first section A11, in which a temperature of the battery cells 291 to 299 is in a range of 0° to less than the first reference temperature T11, as a section to which a weighting is applied, and may set a fourth section A14, in which a temperature of the battery cells 291 to 299 is the first reference temperature T11 or more, as a section to which a weighting is applied according to cell damage.

In the fourth section A14, the processor 210 may set the second section A12, in which a temperature is in a range of the first reference temperature T11 or more to less than the second reference temperature T12, as a section to which a variable weighting is applied, and may set the third section A13, in which a temperature is the second reference temperature T12 or more, as a section to which a maximum weighting is applied.

When a measured temperature is included in the second section A12 which is the section to which the variable weighting is applied, the processor 210 sets a weighting to increase as a temperature increases. The processor 210 may set a variable weighting for the second section A12 based on a weighting table stored in the memory 220.

In addition, when a temperature is included in the third section A13 which is the section to which the maximum weighting is applied, the processor 210 may set a maximum weighting w.

The processor 210 may set a weighting for temperature variably according to a level or section and then may calculate a degree of damage to the battery cells 291 to 299 according to a time exceeding a safety range.

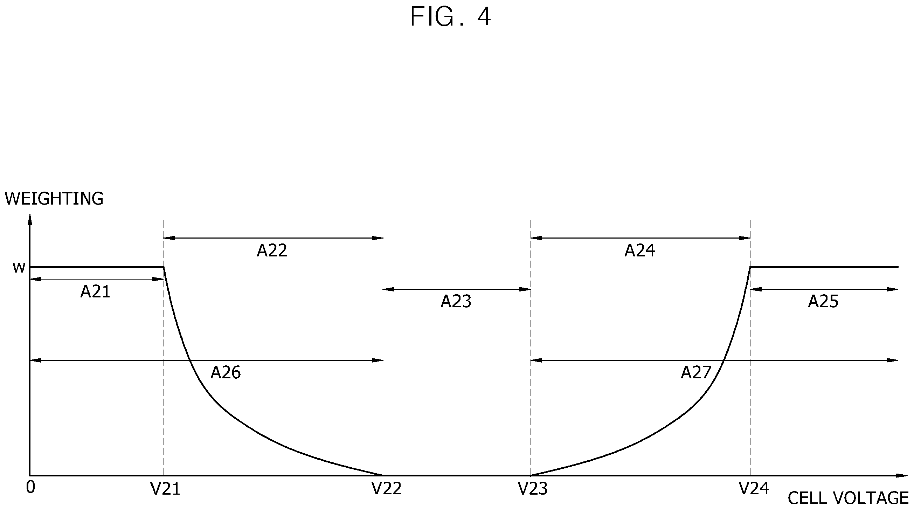

FIG 4 shows a section, to which a weighting is applied, according to a voltage in the apparatus for predicting damage to a battery cell according to one embodiment of the present disclosure.

Referring to FIG 4, the processor 210 may divide levels according to a voltage of the battery cells 291 to 299 and may variably set a weighting.

When a measured voltage is a second reference voltage V22 or more and less than a third reference voltage V23 and included in a safety range, the processor 210 determines that the measured voltage is a normal voltage and does not set a weighting.

For any one of a case in which a measured voltage is less than the second reference voltage V22 or a case in which a measured voltage is the third reference voltage V23 or more, the processor 210 may set a section as a section to which a weighting is applied according to cell damage.

The processor 210 may set a fifth section A21 in which a temperature is less than the first reference voltage V21, a sixth section A22 in which a temperature is in a range of the first reference voltage V21 or more to less than the second reference voltage V22, a seventh section A23 in which a temperature is in a range of the second reference voltage V22 or more to less than the third reference voltage V23, an eighth section A24 in which a temperature is in a range of the third reference voltage V23 or more to less than a fourth reference voltage V24, and a ninth section A25 in which a temperature is the reference voltage V24 or more.

In this case, the seventh section A23 is a section corresponding to a safety range and is a section in which a weighting is not set.

When a measured voltage is included in any one of the fifth section A21 and the ninth section SA25, the processor 210 may set a maximum weighting w.

In addition, when a measured voltage is included in any one of the sixth section A22 and the eighth section A24, the processor 210 may set a variable weighting according to a magnitude of the measured voltage. The processor 210 may set a weighting to decrease from the maximum weighting w as a voltage increases in the sixth section A22 and may set a weighting to increase as a voltage rises in the eighth section A24.

The processor 210 may calculate a weighting based on a temperature or voltage to calculate a degree of damage to the battery cells 291 to 299.

When a measured temperature or voltage deviates from a safety range (that is, is included in a cell damage range), the processor 210 applies a control signal to the contactor 250 to block a battery output. In addition, the processor 210 may limit the use of at least one of the plurality of battery cells 291 to 299.

In this case, the processor 210 may calculate a degree of damage according to a time for which the plurality of battery cells 291 to 299 are exposed at a corresponding temperature and voltage until the plurality of battery cells 291 to 299 are blocked by the contactor 250. In addition, the processor 210 may calculate a degree of damage based on the number at which at least one of a temperature and a voltage is included in a cell damage range.

The processor 210 may accumulate a degree of damage and store the degree of accumulated damage in the memory 220 and may determine whether to permanently block the contactor 250 or replace the battery cells 291 to 299 based on the degree of accumulated damage.

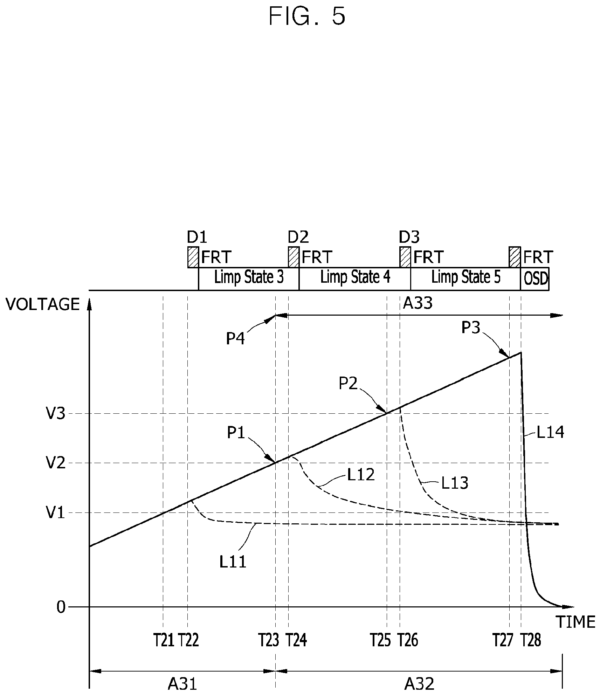

FIG 5 shows a cell damage section according to a level of an output factor in the apparatus for predicting damage to a battery cell according to one embodiment of the present disclosure.

Referring to FIG 5, the processor 210 may set a level based on a possibility of damage to the battery cells 291 to 299 and a degree of damage to the battery cells 291 to 299 according to any one of a temperature and a voltage.

In an area (QM range) A31, the processor 210 may set a normal area, in which damage does not occur, to Level 1, and may set an area in which a safety issue is not present, to Level 2.

The processor 210 may divide a damage area A32, (safety range-safety issue), in which damage occurs in the battery cells 291 to 299 with safety issues, into a plurality of levels.

In the area A32 in which the battery cells 291 to 299 are damaged, the processor 210 may set a case, in which a high voltage is blocked within a first time, to Level 3. The processor 210 may set an area in which the battery cells 291 to 299 is likely to be seriously damaged, that is, a case, in which a high voltage is blocked within a second time shorter than the first time, to a Level 4, and may set an area in which entry is not allowed, to Level 5.

The permissible number of entries at Level 5 may be 0, and the processor 210 may block entry into Level 5 in advance by operating the contactor 250 in Level 4 before entry into Level 5.

For example, the processor 210 may set a time $T_{diag}$ for determining a damage area for about 2 seconds to 3 seconds based on Level 4, may set a time $T_{react}$ for blocking a high voltage, and may set a maximum allowable time $T_{duration}$ for each cell damage area to about 5 seconds to 6 seconds based on about 3 seconds. A presented time is not limited to the example and may be changed according to settings.

In addition, the processor 210 may set a time $T_{duration}$ for each section and the permissible number $N_{repeat}$ for each voltage section for the remaining areas excluding the first level.

The processor 210 may perform first level fault detection D1 at a second reference time T22 when the time $T_{diag}$ of 3 seconds for determining the damage area has elapsed from the first reference time T21.

In this case, when a fault is detected through the first level fault detection D1, the processor 210 may set damage state 3 (Limp State 3) and may set a power limit of the battery cells 291 to 299 to 0 kW to 3 kW.

Accordingly, a voltage L11 of the battery cells 291 to 299 drops by a certain value based on a first voltage V1 from the second reference time T22 and then converges to a voltage value smaller than the first voltage V1. Accordingly, the power of the battery cells 291 to 299 may be generated in a power limit range (0 kW to 3 kW).

After the first level fault detection D1, a fault reaction time (FRT), which is a time allocated up to the third reference time T23 to transition to a stable state after a fault is detected, is set. In the area A31 (QM range) in which damage does not occur, the FRT may be set without limitation.

Based on the third reference time T23 at which the FRT is ended (P1), the processor 210 may perform second level fault detection D2 at a fourth reference time T24 when a certain time (for example, about 1 second) has elapsed from the third reference time T23.

When a fault is detected through the second level fault detection D2, the processor 210 may set as damage state 4 (Limp State 4).

When a fault occurs (P1), the processor 210 performs a power limit of 0 kW to 3 kW on the battery cells 291 to 299 and controls the contactor 250 to be opened within a first time. In this case, the contactor 250 may be opened before a certain time by a control command. For example, the first time may be set in a range of about 25 seconds to about 30 seconds.

Accordingly, a voltage L12 of the battery cells 291 to 299 decreases from a second voltage V2 due to power limit and converges to a voltage value smaller than the first voltage V1.

In addition, when a fault occurs (P1) at the third reference time T23, the processor 210 needs to resolve abnormalities of the battery cells 291 to 299 within a fault tolerant time interval (FTTI) which is a maximum time allowed from the third reference time T23 to ensure functional stability. The FTTI may be a time until a system malfunctions from the occurrence of a fault to cause a problem and may be maintained during a tenth section A33.

After the second level fault detection D2, up to a sixth reference time T26, the processor 110 may set an FRT which is a time allocated to transition to a stable state after a fault is detected. In damage state 4, the FRT may be set within up to 30 seconds.

Based on a fifth reference time T25 (P2), the processor 210 may perform third level fault detection D3 at the sixth reference time T26 when a certain time (for example, about 1 second) has elapsed from the fifth reference time T25.

When a fault is detected through third level fault detection D3, the processor 210 sets damage state 5 (Limp State 5).

The processor 210 performs a power limit of 0 kW to 3 kW on the battery cells and controls the contactor 250 to be opened within a second time. For example, the second time may be set within about 2 seconds to 3 seconds.

Accordingly, a voltage L13 of the battery cells 291 to 299 decreases to a third voltage V3 or less due to the power limit and converges to a voltage value smaller than the first voltage V1.

After the third level fault detection D3, up to a seventh reference time T27, the processor 210 may set an FRT which is a time allocated to transition to a stable state after a fault is detected. In damage state 5, the FRT may be set within up to 3 seconds.

The processor 210 may perform fourth level fault detection at the seventh reference time T27. However, since a subsequent area is an area in which the permissible number of detections at Level 5 is 0, which deviates from a final acceptable standard, the processor 210 may immediately turn off the operation. In this case, the contactor 250 may be permanently blocked.

The processor 210 may set a weighting based on a damage state and time according to an area in which a fault is detected and may calculate a degree of damage according to the set weighting.

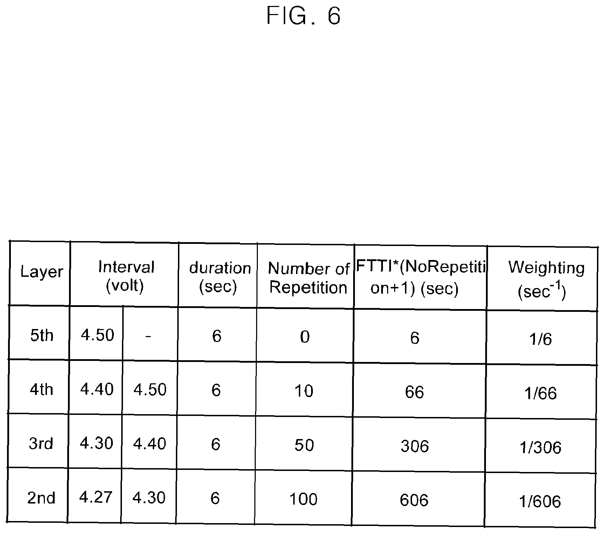

FIG 6 shows a weighting table according to a level of an output factor in the apparatus for predicting damage to a battery cell according to one embodiment of the present disclosure.

Referring to FIG 6, the processor 210 may set a weighting variably according to damage states based on weighting data stored in the memory 220.

The processor 210 may define a maximum allowable time for each level as $T_{duration} \times (N_{repeat}+1)$ obtained by multiplying a section time unit $T_{duration}$ for each section by a value obtained by adding 1 to the permissible number and may define a weighting (weighting=1/FTTI) based thereon.

For example, the processor 210 may set 1/606 as a weighting because the FTTI is 606 at Level 2 and may set 1/66 as a weighting because the FTTI is 66 at Level 4.

The processor 210 may accumulate a weighting for each time for entering each level, and when an accumulated weighting deviates from a final allowable standard (set value), the processor 210 may determine that a possibility of cell damage is high.

The processor 210 may calculate an accumulated weighting according to a degree of cell damage as shown in Equation 1 below.

[Equation 1]

$$
\begin{aligned}
Weighting(\sec^{-1}) &= \frac{1}{FTTI} \\
&= \frac{1}{T_{duration} \times (N_{repeat+1})} \\
&= \frac{1}{(T_{diag} + T_{react}) \times (N_{repeat}+1)}
\end{aligned}
$$

$T_{diag}$ denotes a time for determining a safety range (safety range), $T_{react}$ denotes a time for blocking a high voltage, $T_{duration}$ denotes a time to stay in an area in which cell damage occurs, and $N_{repeat}$ denotes the permissible number for each voltage section.

The processor 210 may accumulate a degree of damage and store the degree of accumulated damage in the memory 220 and may determine whether to block the contactor 250 or replace the battery cells 291 to 299 based on the degree of accumulated damage.

When it is determined that one of the battery cells 291 to 299 needs to be replaced, the processor 210 may generate a request signal for replacing the battery cells 291 to 299 to transmit the generated request signal through the communication unit 230 or an output component.

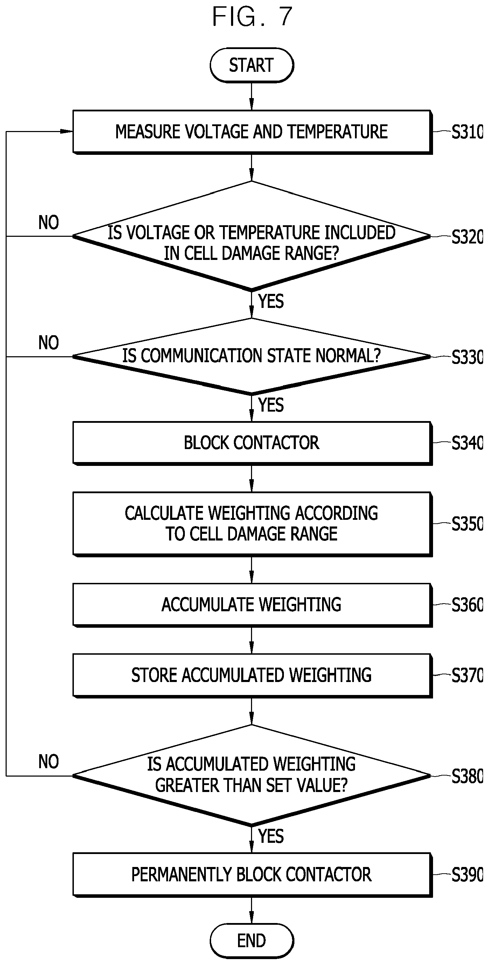

FIG 7 illustrates a method of predicting damage to a battery cell in the apparatus for predicting damage to a battery cell according to one embodiment of the present disclosure.

Referring to FIG 7, the processor 210 measures a temperature and voltage of the plurality of battery cells 291 to 299 using the temperature sensor 241 and the voltage sensor 242 (S310).

The processor 210 determines whether the temperature or voltage is in a cell damage range (S320).

When the temperature or voltage is included in the cell damage range, the processor 210 determines whether a communication state of the communication unit 230 is normal (S330).

When the temperature or voltage is in a normal state in a safety range, the processor 210 continuously monitors the temperature and voltage through the sensor 240.

Meanwhile, when the communication state is abnormal, the processor 210 may determine that data from the sensor 240 is invalid. In this case, the processor 210 may generate a communication error.

When the communication state of the communication unit 230 is normal and the temperature or voltage is included in the cell damage range, the processor 210 determines that data from a sensor included in the cell damage range is valid and generates an error code because there is a possibility of cell damage.

In addition, the processor 210 controls the contactor 250 to block the connection between the battery module 290 or battery cells 291 to 299 and a load or an apparatus in which the prediction apparatus 200 is installed (S340). The processor 210 may variably set an operation time of the contactor 250 based on a level according to a damage range.

The processor 210 calculates a weighting according to the cell damage range (S350). The processor 210 accumulates a weighting for damage to the battery cells (S360) and stores data about the accumulated weighting in the memory 220 (S370).

The processor 210 compares the accumulated weighting with a set value and controls the contactor 250 to be permanently blocked when the accumulated weighting is greater than the set value (S390). Accordingly, the battery module 290 is disconnected from an apparatus or a device by the contactor 250.

The processor 210 may transmit data about a permanent block of the contactor 250 and battery damage through the communication unit 230 or output the data through an output component. In addition, the processor 210 may request replacement of the battery cells 291 to 299.

Therefore, according to the apparatus and method for predicting a damage to a battery cell, a damage history of the battery cells 291 to 299 may be stored, and a degree of damage to the battery cells 291 to 299 can be accurately predicted based on the stored damage history. In addition, according to the present disclosure, the battery cells 291 to 299 can be effectively managed by replacing the battery cells 291 to 299 according to a degree of damage to the battery cells 291 to 299.

According to the present disclosure, damage to a battery cell can be accurately predicted based on a magnitude and time of a voltage or temperature that deviates from a safety range.

According to the present disclosure, it is possible to effectively manage a history of a case in which a voltage or temperature deviates from a safety range.

According to the present disclosure, it is possible to effectively manage a battery cell by predicting damage accumulated in the battery cell.

However, the effects that can be achieved through the present disclosure are not limited to the above-described effects, and other technical effects not described herein will be clearly understood by those skilled in the art from the following disclosure.

Although the present disclosure has been described with limited embodiments and drawings, the present disclosure is not limited to thereto, and instead, it would be appreciated by those skilled in the art that various modifications and changes may be made to these embodiments without departing from the principles of the present disclosure, the scope of which is defined by the claims and their equivalents.

Implementations described herein may be implemented in, for example, a method or process, an apparatus, a software program, a data stream, or a signal. Although discussed only in the context of a single form of implementation (e.g., discussed only as a method), implementations of the discussed features may also be implemented in other forms (for example, an apparatus or a program). The apparatus may be implemented in suitable hardware, software, firmware, and the like. A method may be implemented in an apparatus such as a processor, which is generally a computer, a microprocessor, an integrated circuit, a processing device including a programmable logic device, or the like. Processors also include communication devices such as a computer, a cell phone, a portable/personal digital assistant ("PDA"), and other devices that facilitate communication of information between end-users.

Here, the processor may be implemented as a central processing unit (CPU) or a system on chip (SoC), may drive an operating system or application to control a plurality of hardware or software components connected to the processor, and may process various pieces of data and perform calculations. The processor may be configured to execute at least one instruction stored in a memory (not shown) and store execution result data in the memory.

The present disclosure has been described with reference to embodiments shown in the drawings, but this is merely illustrative, and those skilled in the art will understand that various modifications and other equivalent embodiments are possible therefrom. Therefore, the technical protection scope of the disclosure should be defined by the appended claims.

Embodiments are set out in the following clauses:

1. An apparatus for predicting damage to a battery cell, the apparatus comprising:

   a battery module including a plurality of battery cells;
   a voltage sensor configured to measure a voltage of the battery cell;
   a temperature sensor configured to measure a temperature of the battery cell;
   a contactor configured to connect or disconnect the battery module; and
   a processor configured to, when at least one of the voltage and the temperature is included in a cell damage range for the battery cell, control the contactor to disconnect the battery module and calculate a weighting to determine a degree of damage to the battery cell according to at least one of the voltage and the temperature.

2. The apparatus of clause 1, wherein the processor accumulates and stores the weighting and finally determines the degree of damage to the battery cell based on the accumulated weighting.

3. The apparatus of clause 2, wherein the processor compares the accumulated weighting with a set value and permanently blocks the contactor when the accumulated weighting is greater than the set value.

4. The apparatus of clause 1, 2 or 3, wherein the processor calculates a variable weighting when the temperature is in a range of a first reference temperature or more to less than a second reference temperature and calculates a maximum weighting when the temperature is the second reference temperature or more.

5. The apparatus of any preceding clause, wherein the processor sets a maximum weighting for any one of a case in which the voltage is less than a first reference voltage and a case in which the voltage is a fourth reference voltage or more and sets a variable weighting for any one of a case in which the voltage is in a range of the first reference voltage or more to less than a second reference voltage and a case in which the voltage is in a range of a third reference voltage or more to less than the fourth reference voltage.

6. The apparatus of any preceding clause, wherein the processor divides the cell damage range into a plurality of levels and calculates the weighting variably according to a level to which the temperature or the voltage belongs.

7. The apparatus of clause 6, wherein the processor calculates the weighting by setting a time unit, a permissible number, and a maximum allowable time for each section variably according to the level.

8. The apparatus of clause 6 or 7, wherein the processor calculates a value, which is obtained by dividing 1 by a maximum fault tolerant time interval (FTTI) allowed to ensure functional stability set variably according to the level, as the weighting.

9. A method of predicting damage to a battery cell, the method comprising:

measuring, by a voltage sensor, a voltage of a plurality of battery cells and measuring, by a temperature sensor, a temperature of the battery cells;
determining, by a processor, whether at least one of the voltage and the temperature is included in a cell damage range of the battery cell;
when at least one of the voltage and the temperature is included in the cell damage range, controlling, by the processor, the contactor to disconnect the battery module; and
calculating a weighting for a degree of damage to the battery cell according to at least one of the voltage and the temperature.

10. The method of clause 9, further comprising, after the calculating of the weighting, accumulating and storing, by the processor, the weighting and finally determining the degree of damage to the battery cell based on the accumulated weighting.

11. The method of clause 10, further comprising comparing, by the processor, the accumulated weighting with a set value, and when the accumulated weighting is greater than the set value, controlling the contactor to be permanently blocked.

12. The method of clause 9, 10 or 11, wherein, in the determining of whether at least one of the voltage and the temperature is included in the cell damage range, the processor sets a variable weighting when the temperature is in a range of a first reference temperature or more to less than a second reference temperature and sets a maximum weighting when the temperature is the second reference temperature or more.

13. The method of any one of clauses 9 to 12, wherein, in the determining of whether at least one of the voltage and the temperature is included in the cell damage range, the processor sets a maximum weighting for any one of a case in which the voltage is less than a first reference voltage and a case in which the voltage is a fourth reference voltage or more and sets a variable weighting for any one of a case in which the voltage is in a range of the first reference voltage or more to less than a second reference voltage and a case in which the voltage is in a range of a third reference voltage or more to less than the fourth reference voltage.

14. The method of any one of clauses 9 to 13, wherein, in the calculating of the weighting, the processor divides the cell damage range into a plurality of levels and calculates the weighting variably according to a level to which the temperature or the voltage belongs.

15. The method of clause 14, wherein, in the calculating of the weighting, the processor calculates the weighting by setting a time unit, a permissible number, and a maximum allowable time for each section variably according to the level.

**Claims**

1. An apparatus for predicting damage to a battery cell, the apparatus comprising:

   a battery module including a plurality of battery cells;
   a voltage sensor configured to measure a voltage of a battery cell of the plurality of battery cells;
   a temperature sensor configured to measure a temperature of the battery cell;
   a contactor configured to connect or disconnect the battery module; and
   a processor configured to, in response to at least one of the voltage and the temperature being included in a cell damage range for the battery cell, control the contactor to disconnect the battery module and calculate a weighting to determine a degree of damage to the battery cell according to at least one of the voltage and the temperature.

2. The apparatus of claim 1, wherein the processor accumulates and stores the weighting and finally determines the degree of damage to the battery cell based on the accumulated weighting.

3. The apparatus of claim 2, wherein the processor compares the accumulated weighting with a set value and permanently blocks the contactor in response to the accumulated weighting being greater than the set value.

4. The apparatus of claim 1, 2 or 3, wherein the processor calculates a variable weighting in response to the temperature being in a range of a first reference temperature or more to less than a second reference temperature and calculates a maximum weighting in response to the temperature being the second reference temperature or more.

5. The apparatus of any preceding claim, wherein the processor sets a maximum weighting for any one of a case in which the voltage is less than a first reference voltage and a case in which the voltage is a fourth reference voltage or more and sets a variable weighting for any one of a case in which the voltage is in a range of the first reference voltage or more to less than a second reference voltage and a case in which the voltage is in a range of a third reference voltage or more to less than the fourth reference voltage.

6. The apparatus of any preceding claim, wherein the processor divides the cell damage range into a plurality of levels and calculates the weighting variably according to a level to which the temperature or the voltage belongs.

7. The apparatus of claim 6, wherein the processor calculates the weighting by setting a time unit, a permissible number, and a maximum allowable time for each section variably according to the level.

8. The apparatus of claim 6 or 7, wherein the processor calculates a value, which is obtained by dividing 1 by a maximum fault tolerant time interval (FTTI) allowed to ensure functional stability set variably according to the level, as the weighting.

9. A method of predicting damage to a battery cell, the method comprising:

   measuring, by a voltage sensor, a voltage of a battery cell of a plurality of battery cells of a battery module and measuring, by a temperature sensor, a temperature of the battery cell;
   determining, by a processor, whether at least one of the voltage and the temperature is included in a cell damage range of the battery cell;
   in response to at least one of the voltage and the temperature being included in the cell damage range, controlling, by the processor, a contactor to disconnect the battery module; and
   calculating a weighting for a degree of damage to the battery cell according to at least one of the voltage and the temperature.

10. The method of claim 9, further comprising, after the calculating of the weighting, accumulating and storing, by the processor, the weighting and finally determining the degree of damage to the battery cell based on the accumulated weighting.

11. The method of claim 10, further comprising comparing, by the processor, the accumulated weighting with a set value, and in response to the accumulated weighting being greater than the set value, controlling the contactor to be permanently blocked.

12. The method of claim 9, 10 or 11, wherein, in the determining of whether at least one of the voltage and the temperature is included in the cell damage range, the processor sets a variable weighting in response to the temperature being in a range of a first reference temperature or more to less than a second reference temperature and sets a maximum weighting in response to the temperature being the second reference temperature or more.

13. The method of any one of claims 9 to 12, wherein, in the determining of whether at least one of the voltage and the temperature is included in the cell damage range, the processor sets a maximum weighting for any one of a case in which the voltage is less than a first reference voltage and a case in which the voltage is a fourth reference voltage or more and sets a variable weighting for any one of a case in which the voltage is in a range of the first reference voltage or more to less than a second reference voltage and a case in which the voltage is in a range of a third reference voltage or more to less than the fourth reference voltage.

14. The method of any one of claims 9 to 13, wherein, in the calculating of the weighting, the processor divides the cell damage range into a plurality of levels and calculates the weighting variably according to a level to which the temperature or the voltage belongs.

15. The method of claim 14, wherein, in the calculating of the weighting, the processor calculates the weighting by setting a time unit, a permissible number, and a maximum allowable time for each section variably according to the level.

# FIG. 1

FIG. 2

FIG. 3

# FIG. 4

WEIGHTING

w

A21

A22

A23

A24

A25

A26

A27

0    V21         V22    V23         V24    CELL VOLTAGE

EP 4 542 242 A1

# FIG. 5

FIG. 6

| Layer | Interval (volt) | | duration (sec) | Number of Repetition | FTTI*(NoRepetition+1) (sec) | Weighting (sec$^{-1}$) |
|-------|------|------|------|------|------|------|
| 5th | 4.50 | - | 6 | 0 | 6 | 1/6 |
| 4th | 4.40 | 4.50 | 6 | 10 | 66 | 1/66 |
| 3rd | 4.30 | 4.40 | 6 | 50 | 306 | 1/306 |
| 2nd | 4.27 | 4.30 | 6 | 100 | 606 | 1/606 |

# FIG. 7

START

MEASURE VOLTAGE AND TEMPERATURE —S310

IS VOLTAGE OR TEMPERATURE INCLUDED IN CELL DAMAGE RANGE? —S320

NO

YES

IS COMMUNICATION STATE NORMAL? —S330

NO

YES

BLOCK CONTACTOR —S340

CALCULATE WEIGHTING ACCORDING TO CELL DAMAGE RANGE —S350

ACCUMULATE WEIGHTING —S360

STORE ACCUMULATED WEIGHTING —S370

IS ACCUMULATED WEIGHTING GREATER THAN SET VALUE? —S380

NO

YES

PERMANENTLY BLOCK CONTACTOR —S390

END

Europäisches Patentamt

European Patent Office

Office européen des brevets

**EUROPEAN SEARCH REPORT**

Application Number

EP 24 18 7805

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/117587 A1 (SUGENO NAOYUKI [JP] ET AL) 27 April 2017 (2017-04-27)<br>* paragraph [0047] - paragraph [0163] *<br>* figure 5 *<br>- - - - - | 1-15 | INV.<br>G01R31/364<br>G01R31/367<br>G01R31/396 |
| A | US 2013/278221 A1 (MAEDA REIZO [JP]) 24 October 2013 (2013-10-24)<br>* paragraph [0038] - paragraph [0055] *<br>- - - - - | 1,9 | |
| A | US 2013/249278 A1 (KAGEYAMA TOMOMI [JP] ET AL) 26 September 2013 (2013-09-26)<br>* paragraph [0022] *<br>- - - - - | 1 | |

TECHNICAL FIELDS
SEARCHED        (IPC)

G01R

The present search report has been drawn up for all claims

| Place of search | Date of completion of the search | Examiner |
|---|---|---|
| The Hague | 22 November 2024 | Breccia, Luca |

EPO FORM 1503 03.82 (P04C01)

## ANNEX TO THE EUROPEAN SEARCH REPORT
## ON EUROPEAN PATENT APPLICATION NO.

EP 24 18 7805

This annex lists the patent family members relating to the patent documents cited in the above-mentioned European search report.
The members are as contained in the European Patent Office EDP file on
The European Patent Office is in no way liable for these particulars which are merely given for the purpose of information.

22-11-2024

| Patent document cited in search report | Publication date | Patent family member(s) | Publication date |
|---|---|---|---|
| US 2017117587 A1 | 27-04-2017 | CA 2944769 A1 | 15-10-2015 |
| | | CN 106133542 A | 16-11-2016 |
| | | EP 3129800 A1 | 15-02-2017 |
| | | JP 6413311 B2 | 31-10-2018 |
| | | JP 2015204149 A | 16-11-2015 |
| | | US 2017117587 A1 | 27-04-2017 |
| | | WO 2015155939 A1 | 15-10-2015 |
| US 2013278221 A1 | 24-10-2013 | EP 2660615 A1 | 06-11-2013 |
| | | JP 6073686 B2 | 01-02-2017 |
| | | JP WO2012091076 A1 | 05-06-2014 |
| | | US 2013278221 A1 | 24-10-2013 |
| | | WO 2012091076 A1 | 05-07-2012 |
| US 2013249278 A1 | 26-09-2013 | BR 102013002237 A2 | 14-07-2015 |
| | | CN 103326451 A | 25-09-2013 |
| | | EP 2642575 A1 | 25-09-2013 |
| | | HK 1189302 A1 | 30-05-2014 |
| | | JP 6184111 B2 | 23-08-2017 |
| | | JP 2013226031 A | 31-10-2013 |
| | | US 2013249278 A1 | 26-09-2013 |

EPO FORM P0459

For more details about this annex : see Official Journal of the European Patent Office, No. 12/82